Europäisches Patentamt

European Patent Office

Office européen des brevets

(11) Veröffentlichungsnummer: **0 309 744**
**A2**

## (12) EUROPÄISCHE PATENTANMELDUNG

(21) Anmeldenummer: 88113987.7

(22) Anmeldetag: 26.08.88

(51) Int. Cl.⁴: **G02B 6/12 , H01S 3/19**

(30) Priorität: 29.09.87 DE 3732821

(43) Veröffentlichungstag der Anmeldung:
05.04.89 Patentblatt 89/14

(84) Benannte Vertragsstaaten:
**DE FR GB**

(71) Anmelder: **Siemens Aktiengesellschaft Berlin
und München**
**Wittelsbacherplatz 2**
**D-8000 München 2(DE)**

(72) Erfinder: **Schimpe, Robert, Dr.**
**Georg-Kerschenst.-Strasse 56**
**D-8012 Ottobrunn(DE)**

(54) **Anordnung mit einem flächig sich erstreckenden Dünnfilmwellenleiter.**

(57) Es wird eine Anordnung mit einem flächig sich erstreckenden Dünnfilmwellenleiter angegeben, bei der eine Verkopplung von in dem Dünnfilmwellenleiter geführten Wellen und eine Auskopplung dieser Wellen senkrecht zum flächigen Dünnfilmwellenleiter ermöglicht ist.

Dazu sind in oder an dem Dünnfilmwellenleiter (DFW) eine Struktur aus mehreren mit Abstand nebeneinander verlaufenden Streifenwellenleitern (StW) und ein Beugungsgitter (BG1) mit in Richtung senkrecht zur Verlaufsrichtung der Streifenwellenleiter verlaufenden Gitterlinien (GL1) ausgebildet. Der Abstand ($b_1$) zwischen benachbarten Gitterlinien (GL1) ist gleich der Wellenlänge ($\lambda$) einer im Dünnfilmwellenleiter (DFW) und in den Streifenwellenleitern (StW) ausbreitungsfähigen elektromagnetischen Welle.

Anwendung für Vorrichtungen, die Laserstrahlung relativ hoher Leistung und starker Bündelung benötigen.

FIG 1

EP 0 309 744 A2

## Anordnung mit einem flächig sich erstreckenden Dünnfilmwellenleiter

Die Erfindung betrifft eine Anordnung mit einem flächig sich erstreckenden Dünnfilmwellenleiter.

Aufgabe der Erfindung ist es, eine Anordnung der genannten Art anzugeben, bei der eine Verkopplung von in dem Dünnfilmwellenleiter geführten Wellen und eine Auskopplung und/oder Einkopplung solcher Wellen aus bzw. in diesen flächigen Dünnfilmwellenleiter ermöglicht ist.

Diese Aufgabe wird durch die im kennzeichnenden Teil des Patentanspruchs 1 angegebenen Merkmale gelöst.

Wichtig ist, daß bei der erfindungsgemäßen Anordnung die entlang den Streifenwellenleitern und in dem Dünnfilmwellenleiter geführte Welle mit dem Beugungsgitter in Wechselwirkung steht. Zusätzlich verkoppelt das Beugungsgitter die genannte geführte Welle mit einem Strahl, der im wesentlichen senkrecht zur Verlaufsrichtung der Streifenwellenleiter und senkrecht zu den Gitterlinien steht und der auf einen Punkt fokussiert sein kann.

Bevorzugte und vorteilhafte Ausgestaltungen der erfindungsgemäßen Anordnung gehen aus den Ansprüchen 2 bis 27 hervor.

Die Anordnung nach Anspruch 4 hat den Vorteil, daß die Intensität der entlang der Streifenwellenleiter geführten Welle zu den Endflächen der Streifenwellenleiter hin abnimmt und damit einhergehende geringe Auskopplung von Energie der geführten Welle an den Endflächen eine stärkere Kopplung zwischen der geführten Welle und dem genannten Strahl bewirken kann.

Die Anordnung nach Anspruch 6 hat den Vorteil, daß auf Gitterbereiche, in denen benachbarte Gitterlinien verschiedene Abstände aufweisen, wie dies bei der Anordnung nach Anspruch 4 der Fall ist, verzichtet werden kann. Um die Funktion des Beugungsgitters mit dem einen Abstand zwischen benachbarten Gitterlinien besonders effizient zu gestalten, sollten die genannten Gitterlinien in geeigneten Phasenebenen des stehenden Wellenfeldes ausgebildet sein, das im Dünnfilmwellenleiter durch die in Anspruch 6 genannten Spiegel erzeugt wird.

Eine weitere Erhöhung des Gütefaktors der erfindungsgemäßen Anordnung läßt sich erreichen, wenn die im Anspruch 7 angegebenen Maßnahmen ergriffen werden. Dabei sollten die dort genannten Spiegel so plaziert werden, daß die Verkopplung der in den Streifenwellenleitern geführten Welle vorteilhaft beeinflußt wird.

Zur Überlagerung von Strahlen von mehreren Resonatoren im Sinne der Erfindung oder zur Erhöhung des Auskoppelwirkungsgrades der als Resonator wirkenden erfindungsgemäßen Anordnung in den genannten Strahl, der aus dem Dünnfilmwellenleiter austritt, kann die im Anspruch 8 angegebene Maßnahme ergriffen werden. Durch den dort genannten Spiegel kann ein in Richtung dieses Spiegels aus dem Dünnfilmwellenleiter austretender Strahl dem in der entgegengesetzten Richtung austretenden Strahl überlagert werden.

Der Auskoppelwirkungsgrad kann auch durch die in Anspruch 9 beschriebene Anordnung erhöht werden. Durch eine geeignet im Dünnfilmwellenleiter angeordnete Schicht mit einer optisch hochreflektierenden Oberfläche kann die ausgekoppelte Leistung in einem unidirektionalen Strahl zusammengefaßt werden.

Im Hinblick auf die Fokussierung des aus dem Dünnfilmwellenleiter senkrecht zu dessen Fläche austretenden Strahls sind die Ansprüche 11 bis 13 von Bedeutung. Insbesondere im Hinblick auf eine Fokussierung dieses Strahls auf einen Punkt ist es von Vorteil, die im Anspruch 13 angegebenen Maßnahme zu ergreifen.

Weitere bevorzugte und vorteilhafte Ausgestaltungen erfindungsgemäßer Anordnungen gehen aus den Ansprüchen 14 bis 32 hervor.

Vorteilhaft ist es insbesondere, eine erfindungsgemäße Anordnung nach Anspruch 22 zu gestalten, die vorzugsweise gemäß Anspruch 26 ausgebildet sein und vorteilhaft insbesondere in Verbindung mit den Merkmalen des Anspruchs 14 als Halbleiter-Injektionslaser verwendbar ist.

Die Erfindung wird anhand der Figuren in der nachfolgenden Beschreibung beispielhaft näher erläutert. Von den Figuren zeigen:

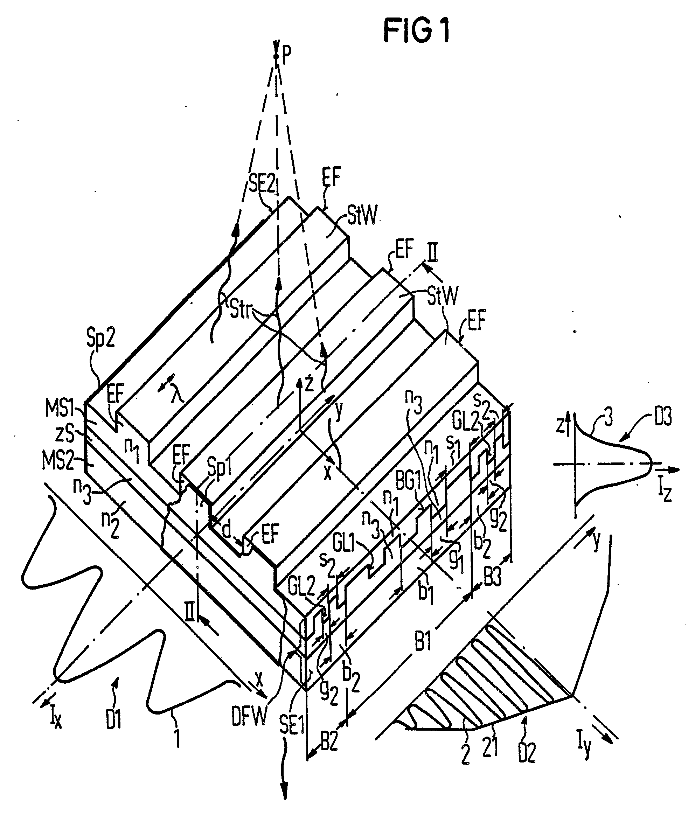

Figur 1 eine schematische perspektivische Darstellung einer Anordnung mit einem Gitter, mit der Besonderheit, daß das Gitter verschiedene Abstände zwischen benachbarten Gitterlinien aufweist,

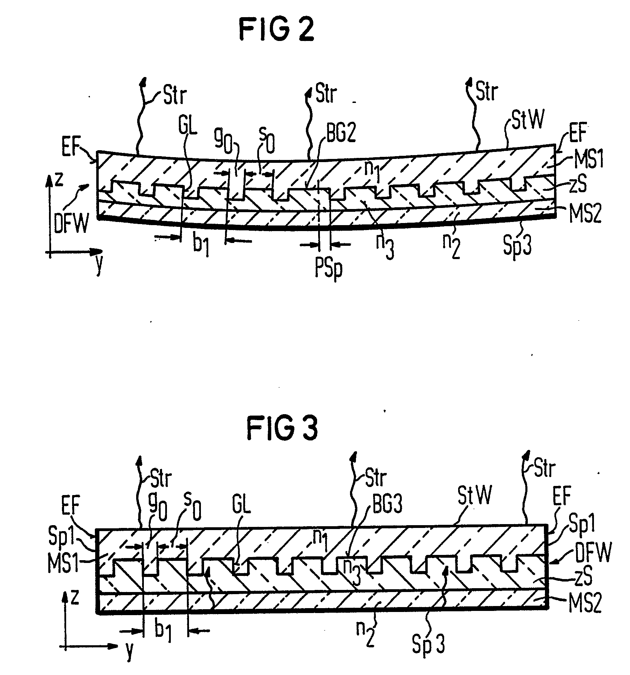

Figur 2 einen vertikalen Schnitt durch eine Anordnung nach Figur 1 längs der Schnittlinie II-II, mit der Besonderheit, daß das Beugungsgitter einen festen Abstand zwischen benachbarten Gitterlinien und einen Phasensprung aufweist, und bei der der Dünnfilmwellenleiter leicht kugelförmig gekrümmt ist,

Figur 3 einen vertikalen Schnitt durch eine Anordnung nach Figur 1 längs der Schnittlinie II-II mit der Besonderheit, daß das Beugungsgitter einen festen Abstand zwischen benachbarten Gitterlinien aufweist und bei der insbesondere an stirnseitigen Endflächen der Streifenwellenleiter Spiegel vorgesehen sind,

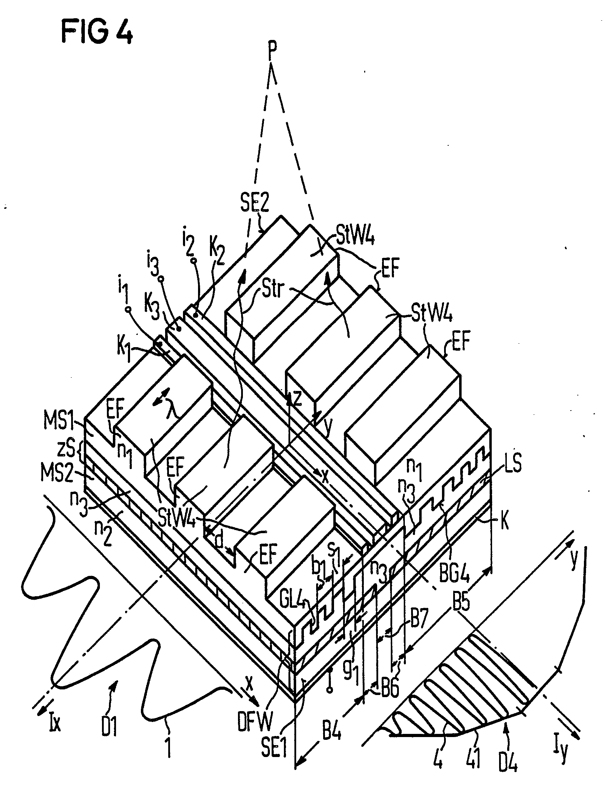

Figur 4 eine schematische perspektivische Darstellung einer Anordnung nach Figur 1, mit der Besonderheit, daß in einem inneren Bereich des Dünnfilmwellenleiters die Streifenwellenleiter und das Beugungsgitter nicht ausgeführt sind und der Wellenleiter eine laseraktive Schicht aufweist, und

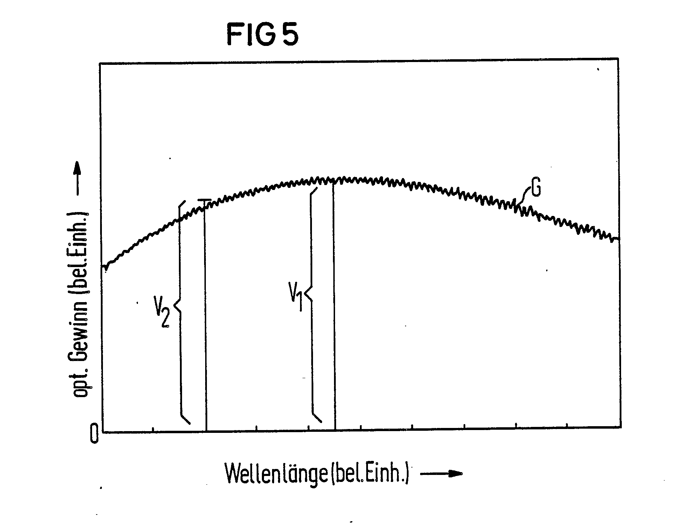

Figur 5 ein Diagramm zur Darstellung des optischen Gewinns G als Funktion zur optischen Wellenlänge. Zusätzlich sind der Resonatorverlust V1 des Modes mit dem höchsten Koppelwirkungsgrad zwischen vom Dünnfilmwellenleiter geführter Welle und ausgekoppeltem Strahl und der Resonatorverlust V2 des spektral nächstgelegenen Modes mit einem Resonatorverlust kleiner als V1 eingetragen.

In den Figuren sind übereinstimmende Teile mit den gleichen Bezugszeichen versehen.

Bei allen dargestellten Anordnungen kann der flächige Dünnfilmwellenleiter leicht, beispielsweise kugelförmig, gekrümmt sein, jedoch ist eine solche Krümmung nur in der Figur 2 angedeutet, während diese Krümmung in den Figuren 1, 3 und 4 nicht dargestellt ist.

Zur Orientierung sind die Figuren mit karthesischen Koordinaten x, y und z versehen.

Der Dünnfilmwellenleiter DFW besteht beispielsweise aus einer zentralen wellenübertragenden Schicht zS und zwei wellenübertragenden Mantelschichten MS1, MS2, zwischen denen die zentrale Schicht zS angeordnet ist.

Die Brechzahl $n_3$ der zentralen Schicht zS ist höher als die Brechzahl $n_1$ und $n_2$ der Mantelschichten MS1, MS2. Die zentrale Schicht zS und die Mantelschichten MS1, MS2 wirken deshalb in z-Richtung als Wellenleiter für elektromagnetische oder auch akustische Strahlung.

Die Grenzfläche einer Schicht, beispielsweise die äußere Grenzfläche der Mantelschicht MS1, enthält eine Vielzahl von Stegen und Gräben, die parallel zur y-Achse verlaufen. Im Bereich eines Steges ist die Geschwindigkeit einer parallel zur y-Achse wandernden elektromagnetischen oder akustischen Welle niedriger als seitlich des Steges. Ein Steg und dessen benachbarte Gräben wirken deshalb in y-Richtung als Streifenwellenleiter StW für elektromagnetische oder akustische Strahlung. Bedingt durch einen kleinen räumlichen Abstand d zwischen benachbarten Streifenwellenleitern StW können die geführten Wellen teilweise verkoppelt sein.

An einer anderen Grenzfläche, beispielsweise der Grenzfläche zwischen der zentralen Schicht zS und einer Mantelschicht, beispielsweise der Mantelschicht MS2, sind eine Vielzahl von Stegen und Gräben vorgesehen, die im wesentlichen parallel zur x-Achse und damit senkrecht zur Verlaufsrichtung der Streifenwellenleiter StW verlaufen und so ein eindimensionales Beugungsgitter BG1 für entlang den Streifenwellenleitern StW geführte Wellen bilden. Das Beugungsgitter BG1 weist einen inneren Gitterbereich B1 mit dem einen Abstand $b_1$ zwischen benachbarten Gitterlinien GL1 auf, der zwischen zwei Gitterbereichen B2 und B3 dieses Gitters BG1 mit einem anderen Abstand $b_2$ zwischen benachbarten Gitterlinien GL2 angeordnet ist. Der andere Abstand $b_2$, bezogen auf die Wellenlänge einer in den Gitterbereichen B2 und B3 im Dünnfilmwellenleiter geführten Welle, ist etwa halb so groß wie der eine Abstand $b_1$, bezogen auf die Wellenlänge einer im Gitterbereich B1 geführten Welle. Die Breite der Stege des Beugungsgitters BG1 im inneren Bereich B1 ist mit $s_1$ und die Breite der Gräben in diesem inneren Bereich B1 ist mit $g_1$ bezeichnet. In den beiden äußeren Bereichen B2 und B3 ist die Breite der Stege des Gitters mit $s_2$ und die Breite der Gräben mit $g_2$ bezeichnet. In jedem Gitterbereich B1, B2 und B3 ist die Breite $s_1$ bzw. $s_2$ der Stege etwa gleich der Breite $g_1$ bzw. $g_2$ der Gräben.

Es wird nun die Funktion der Anordnung nach Figur 1 als Resonator beschrieben, wobei die folgenden Überlegungen für den Fall gelten, daß die Wellenlänge $\lambda$ einer entlang eines Streifenwellenleiters StW und damit entlang der y-Achse geführten Welle gleich dem Abstand $b_1$ zwischen benachbarten Gitterlinien GL1 des Beugungsgitters BG1 im inneren Bereich B1 ist. Dann wird eine in den äußeren Bereichen B2 und B3 des Beugungsgitters BG1 wandernde Strahlung zum inneren Bereich B1 dieses Gitters BG1 zurückreflektiert (Gitter erster Ordnung). Im Be reich B1 wandernde Strahlung wird sowohl rückreflektiert als auch in Richtung der z-Achse und damit senkrecht zum Streifenwellenleiter StW ausgekoppelt (Gitter zweiter Ordnung). Dieses Verhalten beruht auf dem Prinzip der konstruktiven Interferenz durch Vielfachreflexion.

Ein großer Teil der ausgekoppelten Strahlung verläßt den Dünnfilmwellenleiter DFW in Richtung der z-Achse und damit senkrecht zur Ebene dieses Wellenleiters als Strahl Str. Wegen der kugelförmigen Krümmung des Dünnfilmwellenleiters DFW ist der Strahl Str in Richtung der z-Achse, beispielsweise in Richtung der positiven z-Achse, auf einen Punkt P auf der z-Achse fokussiert.

Ein Teil der durch das Beugungsgitter senkrecht aus den Streifenwellenleitern StW ausgekoppelten Strahlung wandert als geführte Welle parallel zur x-Achse und damit senkrecht zur Verlaufsrichtung dieser Streifenwellenleiter StW in Richtung der y-Achse. Beim Durchlaufen benachbarter Streifenwellenleiter StW kann das Beugungsgitter BG1 in seinem inneren Bereich B1 Leistung in diese Streifenwellenleiter StW koppeln. Diese Verkopplung der Streifenwellenleiter StW ist extremal, wenn der Abstand d zwischen benachbarten Streifenwellenleitern StW ein ganzzahliges Vielfaches der halben Wellenlänge $\lambda$ der in x-Richtung wandernden Welle beträgt.

Die Figur 1 ist umgeben von Diagrammen D1 bis D3. Die Kurve 1 im Diagramm D1 gibt die Intensitätsverteilung $I_x(x)$ entlang der x-Achse innerhalb der zentralen Schicht zS an. Die Kurve 2 im Diagramm D2 gibt die Intensitätsverteilung $I_y(y)$ entlang der y-Achse innerhalb der zentralen Schicht zS an.

Die Kurve 1 im Diagramm D1 zeigt die Intensitätsverteilung $I_x$ des Grundmodes der gekoppelten Streifenwellenleiter StW an. Die Kurve 1 erreicht Maxima innerhalb der Streifenwellenleiter StW und Minima zwischen den Streifenwellenleitern StW. Geht man von weiter innen liegenden Streifenwellenleitern StW zu weiter außen liegenden Streifenwellenleiter StW, so nehmen die Werte die Maxima zunehmend ab. Diese Intensitätsverteilung über der x-Achse läßt sich erreichen, wenn z.B. durch entsprechende Dimensionierung höhere Moden im System der gekoppelten Streifenwellenleiter StW nicht ausbreitungsfähig sind.

Die Kurve 2 im Diagramm D2 veranschaulicht eine mögliche longitudinale Verteilung $I_y$ der Intensität. In Kurve 2 nimmt $I_y$ ab, wenn man vom Zentrum des Beugungsgitters BG1 in Richtung eines äußeren Gitterbereichs B2 oder B3 dieses Gitters geht. Wie oben ausgeführt, koppelt der zentrale Gitterbereich B1 des Beugungsgitters BG1 Strahlung aus dem Dünnfilmwellenleiter DFW. Dies verursacht einen exponentiellen Abfall der Einhüllenden 21, der durch die Kurve 2 gegebenen Intensitätsverteilung $I_y$. In den äußeren Bereichen B2 und B3 des Beugungsgitters BG1 wird die Strahlung zum Zentrum dieses Gitters zurückreflektiert. Dies verursacht eine im allgemeinen noch stärkere exponentielle Abnahme der Einhüllenden 21 der Kurve 2.

Die Kurve 3 im Diagramm D3 zeigt eine mögliche transversale Verteilung $I_z$ der Intensität innerhalb des Dünnfilmwellenleiters DFW. Diese Kurve 3 zeigt speziell die Intensitätsverteilung des transversalen Grundmodus.

Die in Figur 1 dargestellte Anordnung stellt somit einen Dünnfilmresonator dar, der effiziente Leistungseinkopplung und -auskopplung über einen Strahl Str ermöglicht, der im wesentlichen senkrecht zur Ebene oder der gekrümmten Fläche des Dünnfilmwellenleiters DFW gerichtet ist.

Das in der Figur 1 dargestellte Beugungsgitter BG1 mit dem inneren Gitterbereich B1 und den äußeren Gitterbereichen B2 und B3 läßt sich in einem Beugungsgitter zweiter Ordnung zusammenfassen, bei dem der Abstand $b_1$ zwischen benachbarten Gitterlinien GL1 gleich der Wellenlänge $\lambda$ einer im Dünnfilmwellenleiter DFW und in den Streifenwellenleitern StW ausbreitungsfähigen elektromagnetischen oder akustischen Welle oder gleich einem ganzzahligen Vielfachen (mindestens Zweifachen) der Hälfte dieser Wellenlänge $\lambda$ ist,

und das beispielsweise im Zentrum einen Phasensprung PSp um etwa ein Viertel des genannten Abstandes $b_1$ zwischen benachbarten Gitterlinien GL1 oder etwa um ein ungeradzahliges Vielfaches dieses Viertels aufweist. In der Figur 2 ist eine Anordnung mit einem solchen Gitter BG2 dargestellt. Man erhält durch ein solches Beugungsgitter BG2 eine Vergrößerung der Emissionsfläche und damit einhergehend eine schärfere Bündelung des emittierten Strahles Str.

Um bei einer Anordnung nach Figur 2 mit dem Beugungsgitter BG2 zweiter Ordnung die Reflexion und die vertikale Auskopplung von im Wellenleiter DFW wandernder Strahlung in z-Richtung mit dem Beugungsgitter BG2 zu erzielen, weist dieses Beugungsgitter BG2 vorzugsweise eine Stegbreite $s_0$ oder eine Grabenbreite $g_0$ auf, die etwa gleich einem Viertel des Abstandes $b_1$ der Gitterlinien GL dieses Gitters BG2 zweiter Ordnung ist.

Durch den Phasensprung PSp wird erreicht, daß der Resonator mit verteilter Rückkopplung nächst einer Bragg-Wellenlänge des Beugungsgitters BG2 in Resonanz ist. Wenn die Resonanzwellenlänge des Resonators in der Nähe der Bragg-Wellenlänge des Gitters BG2 liegt, nehmen die Maxima der Intensitätsverteilung $I_x(x)$ (siehe dazu Figur 1) exponentiell von innen nach außen ab. Dieses Abklingen der Intensität ist für effektive Emission in vertikaler z-Richtung vorteilhaft.

Um den Gütefaktor des Resonators zu erhöhen, können an den stirnseitigen Endflächen EF mindestens einer Schicht MS1, zS, MS2 mindestens einer der Streifenwellenleiter StW Spiegel Sp1, beispielsweise in Form von aufgebrachten Spiegelschichten, vorgesehen sein. In der Figur 3 sind solche Spiegel Sp1 vorgesehen und auch in der Figur 1 ist ein solcher Spiegel Sp mit weggebrochenen Teilen gezeigt. In diesem Fall kann auf die äußeren Gitterbereiche B2 und B3 in Figur 1 verzichtet werden und es kann ein Beugungsgitter BG3 vorgesehen sein, wie es aus der Figur 3 hervorgeht. Der Abstand $b_1$ zwischen benachbarten Gitterlinien GL1 dieses Gitters BG3 ist wiederum mindestens gleich der Wellenlänge $\lambda$ einer im Dünnfilmwellenleiter DFW und in den Streifenwellenleitern StW ausbreitungsfähigen elektromagnetischen oder akustischen Welle zu wählen.

Um die Funktion des Beugungsgitters BG3 besonders effizient zu gestalten, sollten dessen Gitterlinien in geeigneten Phasenebenen des durch die Spiegel Sp1 ausgebildeten stehenden Wellenfeldes angeordnet sein.

Eine weitere Erhöhung des Gütefaktors läßt sich durch Spiegel Sp2 an seitlichen Endflächen sE1, sE2 mindestens einer Schicht MS1, zS, MS2 des Dünnfilmwellenleiters DFW erreichen, die etwa in der Verlaufsrichtung, d.h. der y-Richtung der Streifenwellenleiter StW verlaufen. In der Figur 1 ist auf einer solchen Endfläche sE2 ein solcher Spiegel Sp2 in Form einer Spiegelschicht vorgesehen. Die seitlichen Endflächen sE1, sE2 können insbesondere an einer Flanke oder innerhalb eines der Streifenwellenleiter StW liegen. Auch auf der anderen Endfläche sE1 sollte ebenfalls ein solcher Spiegel vorgesehen sein, der jedoch in der Figur 1 weggelassen ist. Die Spiegel Sp2 sollten so plaziert werden, daß eine eventuell gegebene Verkopplung der Streifenwellenleiter StW durch den inneren Gitterbereich B1 des Beugungsgitters BG1 oder durch das Beugungsgitter BG2 oder BG3 vorteilhaft beeinflußt wird.

Um den Auskoppelwirkungsgrad des Resonators in den fokussierten Strahl Str zu erhöhen, kann im Strahlengang einer in einer Richtung, beispielsweise entgegengesetzt zur z-Richtung, senkrecht zur Verlaufsrichtung der Streifenwellenleiter StW und senkrecht zu den Gitterlinien GL1, GL2 aus dem Dünnfilmwellenleiter DFW herausstrahlenden Welle ein Spiegel Sp3 angeordnet sein, der diese Welle in die entgegengesetzte Richtung, d.h. im Beispiel in der z-Richtung, reflektiert und dem in dieser Richtung austretenden, fokussierten Strahl Str überlagert. In der Figur 3 ist ein solcher Spiegel Sp3, der ebenfalls eine Spiegelschicht sein kann, dargestellt. Durch solch einen Spiegel Sp3 können auch die Strahlen Str mehrerer Resonatoren im Sinne der Erfindung einander überlagert werden, die entlang einer Zeile oder in einer Ebene angeordnet sind. Dadurch lassen sich insbesondere die optischen Wellen in diesen Resonatoren phasenstarr koppeln. Es kann vorteilhaft sein, daß der Spiegel Sp3 nicht auf dem Substrat aufgebracht ist, das einen der Dünnfilmwellenleiter trägt, sondern in einem gewissen Abstand zu diesem Substrat angeordnet ist. Zwischen den Resonatoren und dem Spiegel Sp3 können dann auch Linsen zur Lenkung der Strahlen angeordnet sein.

Die Spiegelschicht kann beispielsweise durch eine oder mehrere hochreflektierende Metallschichten, beispielsweise aus Gold, Silber oder Kupfer, oder durch eine oder mehrere dielektrische Schichten gebildet werden. Die Spiegelschicht kann auch Teil des Dünnfilmwellenleiters sein, d.h. die vom Dünnfilmwellenleiter geführte Welle steht mit der Spiegelschicht in Wechselwirkung. Das Beugungsgitter kann auch direkt in die Grenzfläche der Spiegelschicht eingebracht werden. In diesem Fall wird die Spiegelschicht Sp3 durch die Mantelschicht MS2 gebildet und das Gitter ist in der Grenzfläche zwischen der zentralen Schicht zS und der Mantelschicht MS2 ausgebildet.

Bei der Anordnung nach Figur 4 befinden sich in einem äußeren Bereich B4 mit B5 des Dünnfilmwellenleiters DFW die Streifenleiter StW4 und das Beugungsgitter BG4. In den inneren Bereichen B6 und B7 des Dünnfilmwellenleiters DFW sind die Streifenleiter StW4 und das Beugungsgitter BG4 nicht ausgeführt. Im Dünnfilmwellenleiter DFW befindet sich eine (schraffiert gezeichnete) Schicht LS aus Material mit der Fähigkeit zu spontaner Emission oder optisch zu verstärken, die bei Injektion der Ströme $i_1$ und $i_2$ über die Kontaktschichten KS1 und KS2 und die Massekontaktschicht K oder bei optischer Injektion von Licht geeigneter Wellenlänge Strahlung in den Dünnfilmwellenleiter emittiert. Diese Strahlung wird an den Gitterlinien GL4 des Beugungsgitters BG4 reflektiert, so daß sich eine Laserwelle im Resonator aufbauen kann. Die Auskopplung des Laserlichts erfolgt in z-Richtung vertikal zur Ebene des Dünnfilmwellenleiters DFW mit Hilfe der Gitterlinien GL4. Im Bereich B7 ist die Schicht LS nicht ausgeführt. Durch Injektion des Stromes $i_3$, Anlegen einer elektrischen Spannung über die Kontakt schicht K3 und die Massekontaktschicht K oder bei optischer Injektion von Licht geeigneter Wellenlänge wird der Brechungsindex $n_3$ der Schicht veränderbar, so daß die Phase der im Dünnfilmwellenleiter im Bereich B7 geführten Welle kontrolliert veränderbar ist. Durch geeignete Einstellung des Brechungsindex $n_3$ kann so beispielsweise ein Resonator mit Viertelwellenlängen-Phasensprung realisiert werden, ähnlich wie in der Anordnung der Figur 2 durch den Phasensprung PSp. Durch Kontrolle des Brechungsindex $n_3$ kann auch die Charakteristik des Strahls eingestellt werden. Die Kurve 4 im Diagramm D4 der Figur 4 veranschaulicht die Intensitätsverteilung $I_y(y)$ längs der y-Achse, in der die unterbrochenen Streifenwellenleiter StW4 verlaufen. Die Kurve 41 gibt die Einhüllende der durch die Kurve 4 gegebenen Intensitätsverteilung an. Wie man sieht, sind die Endflächen EF der Streifenleiter StW1 relativ wenig durch das optische Feld belastet, wodurch relativ hohe Ausgangsleistungen dieser als Laser betriebenen Anordnung ermöglicht werden. Die Streifenwellenleiter STW1 oder das Gitter BG4 können sich auch in den inneren Bereich B6 und/oder B7 fortsetzen bzw. dort vorhanden sein, z.B. so wie in der Figur 1, 2 oder 3. Die Schicht LS kann auch auf den inneren Bereich B6 beschränkt sein. Eine eventuell im System der gekoppelten Streifenleiter StW4 vorgesehen Maßnahme zur Unterdrückung der Ausbreitung höherer Moden, wie im Zusammenhang mit der Diskussion der Kurve 1 in Figur 1 angesprochen, wird dann nicht durch eine Wechselwirkung zwischen der Schicht LS und einer vom Streifenleiter StW4 und Dünnfilmwellenleiter DFW geführten Welle gestört.

Die Schicht LS kann auch auf die Streifenleiter StW4 oder Bereiche zwischen den Streifenleitern StW4 beschänkt sein. Die Reflexion von im Dünnfilmwellenleiter DFW geführter Strahlung kann auch an den Endflächen EF der Streifenwellenleiter STW4 erfolgen. In diesem Fall kann das Gitter für die vertikale Auskopplung von Strahlungsleistung von in z-Richtung geführten Wellen optimiert werden.

Der Bereich B7 kann auch weggelassen werden. In diesem Fall läßt sich sowohl die Intensität als auch die Phase der vom Dünnfilmwellenleiter DFW geführten Welle im Bereich B6 durch die Ströme $i_1$ und $i_2$ kontrollieren.

Die Verteilung der Ladungsträger in der Schicht LS oder der Schicht mit dem Brechungsindex $n_3$ läßt sich nicht nur durch die Injektion von elektrischen Ladungsträgern über Kontaktschichten K, K1, K2, K3, sondern auch durch optische Einstrahlung und optisches Pumpen einstellen. Deshalb kann die Intensität und die Phase der vom Dünnfilmwellenleiter DFW und von den Streifenleitern StW4 geführten Welle durch optische Einstrahlung kontrolliert werden.

Zur Erläuterung der Funktionsweise ist bei der Anordnung nach Figur 4 die Länge der Streifenleiter in y-Richtung im Vergleich zur Ausdehnung der Kontaktschichten K1, K2, K3 in y-Richtung übertrieben gezeichnet.

Eine Anordnung nach Figur 4 ist eine Realisierung eines Halbleiter-Injektionslasers mit verkoppelten Streifenwellenleitern StW4 oder auch StW, der sich durch Emission senkrecht zur Ebene oder Fläche dieser Streifenwellenleiter auszeichnet. Hierfür ist das Beugungsgitter so dimensioniert, wie im Zusammenhang mit den Figuren 1 bis 4 erläutert, damit der Auskoppelwirkungsgrad zwischen einer vom Dünnfilmwellenleiter geführten Welle und einem Strahl möglichst hoch wird. Durch diese Maßnahme kann der Resonatorverlust so groß werden, daß ohne spezielle Maßnahmen zur Modenselektion nicht der gewünschte Resonatormode, sondern ein Resonatormode mit geringerem Resonatorverlust anschwingt.

Die Funktion einer Anordnung zur Aufrechterhaltung einer Schwingung im Mode mit dem höchsten Auskoppelwirkungsgrad ist in Figur 5 erläutert. In der Figur 5 zeigt die Kurve G den optischen Gewinn der Schicht LS als Funktion der Wellenlänge. Die Linie V1 gibt den Resonatorverlust des Modes mit dem höchsten Auskoppelwirkungsgrad. Die Linie V2 gibt den Reso natorverlust des spektral nächstgelegenen Resonatormodes mit niedrigeren Verlusten als der Mode mit dem höchsten Auskoppelwirkungsgrad. Im Mode mit dem höchsten Koppelwirkungsgrad wird eine Laserschwingung angeregt, da gemäß Figur 5 dessen Resonatorverlust V1 durch den optischen Gewinn G kompensiert wird. Der Mode mit dem niedrigeren Resonatorverlust liegt bei einer Wellenlänge, bei der der optische Gewinn G den Resonatorverlust V2 nicht kompensiert. Ein Anschwingen dieses Resonatormodes wird deshalb nicht unterstützt.

Zur Erzielung von Modenselektion gemäß Figur 5 sollte der Resonator gewisse Mindestwerte für den spektralen Abstand DL benachbarter Moden aufweisen, damit sich die Differenz zwischen optischem Gewinn G und Resonatorverlust V1, V2 von Mode zu Mode genügend stark ändern kann. Solche Modenabstände lassen sich beispielsweise mit Resonatoren erzielen, bei denen die Ausdehnung des stehenden Wellenfeldes in Verlaufsrichtung mindestens eines der Streifenwellenleiter kürzer als 300 Wellenlängen der im Streifenleiter geführten Welle ist. Solch kurze Resonatoren lassen sich beispielsweise mit effizienten Gitterreflektoren erzielen, bei denen wenigstens zwei Materialien, die die das Gitter enthaltende Grenzfläche bilden, stark unterschiedliche optische Konstanten aufweisen. Beispiele für solche Materialkombinationen sind Halbleiter-Isolator, Halbleiter-Metall, Isolator-Metall. Dabei kann der Isolator auch durch Luft bzw. Vakuum realisiert sein.

Für die Anwendung als Halbleiter-Injektionslaser besteht der Dünnfilmwellenleiter DFW vorzugsweise aus einer Doppelheterostruktur, einem Wellenleiter mit dünnen Potentialtopfschichten (MQW-Waveguide, siehe dazu Appl Phys. Lett. Vol. 50, S. 227-229 (1987) oder Jap. J. Appl. Phys., Vol. 26, S. L-176-178 (1987)), einem Wellenleiter mit großem optischem Modenvolumen (LOC-Waveguide, siehe dazu Appl. Phys. Lett. Vol. 38, S. 658 (1981)) oder einem Wellenleiter mit fein gestuften Brechungsindizes (GRIN-SCH-Waveguide, siehe Appl. Phys. Lett. Vol. 50, S. 1773-1775 (1987)). Beispielsweise besteht die zentrale Schicht zS aus $Al_xGa_{1-x}As$ und die Mantelschichten MS1 und MS2 bestehen aus p-oder n-dotiertem $Al_yGa_{1-y}As$, so daß eine Doppelheterostruktur gegeben ist. Der Dünnfilmwellenleiter DFW kann auch eine Schicht aus $Ga_uIn_{1-u}As_vP_{1-v}$ aufweisen.

Eine Anordnung mit Bereich B7 nach Figur 4 ist eine Realisierung eines Phasenmodulators innerhalb eines oberflächenemittierenden Halbleiter-Injektionslasers mit verkoppelten Streifenleitern. Für diese Anwendung enthält der Dünnfilmwellenleiter DFW vorzugsweise eine pin-Struktur und die zentrale Schicht enthält vorzugsweise dünne Potentialtopfschichten (MQW-wave-guide, siehe Appl. Phys. Lett. Vol. 48, (1986). S. 989-991). Beispielsweise ist die zentrale Schicht zS niedrig dotiert oder undotiert und die Mantelschichten MS1 und MS2 bestehen aus p- bzw. n-dotiertem Halbleitermaterial.

Die Streifenwellenleiter StW und StW4 können beispielsweise in Form von Stegen, wie sie in der Figur 1 und 4 dargestellt sind, ausgebildet sein. Sie können auch vergrabene Wellenleiter (Buried-Hetero-Structure Waveguide) oder Wellenleiter mit umgeordneten Potentialtopfschichten (Waveguide with Disordered Quantum Wells, siehe dazu Jap. J. Appl. Phys. Vol. 25, S. L-690-692 (1986)) sein.

Die Streifenwellenleiter können auch über Wellenleiterverzweigungen (Y-junctions, siehe dazu US-PS 4 255 717) verkoppelt sein.

Die Gitterlinien können beispielsweise die Form von Stegen und Gräben aufweisen, wie in Figur 1 dargestellt. Die Gitterlinien können herstellungsbedingt auch andere Formen annehmen, wie sie sich beispielsweise durch Diffusion oder Implantation geeigneter Materialien, z. B. von Silizium-Ionen, ergeben.

In Bezug auf den Stand der Technik wird noch darauf hingewiesen, daß in der genannten Literaturstelle Appl. Phys. Lett., Vol. 50, 1987, S. 227-229 ein Streifenlaser mit einer laseraktiven Schicht aus mehrfachen AlGaAs/GaAs-Potentialtopfschichten (multiple quantum well) beschrieben ist. Die Anordnung weist nur einen Streifenwellenleiter außerhalb eines Bereiches mit einem Beugungsgitter auf, so daß die effiziente Oberflächenemission nicht erzielt wird.

In der genannten Literaturstelle Jap. J. Appl. Phys., Vol. 25, 1986, S. L690-692 werden Wellenleiter mit umgeordneten Potentialtopfschichten (waveguide with disordered quantum wells) beschrieben.

In der genannten Literaturstelle Jap. J. Appl. Phys., Vol. 26, 1987, S. L176-178 werden GaInAsP/InP-Laser mit laseraktivem Material aus Potentialtopfschichten beschrieben.

In der genannten Literaturstelle Appl. Phys. Lett., Vol. 38, 1981, S. 658 werden Halbleiterinjektionslaser mit großem optischem Wellenleiterquerschnitt (large optical cavity, LOC) beschrieben.

In Appl. Phys. Lett, Vol. 50, 1987, S. 659-661 wird über Oberflächenemission von kollinear gekoppelten Streifenlasern berichtet. Die Oberflächenemission von seitlich verkoppelten Streifenwellenleitern ist nicht beschrieben.

In Surface Science, Vol. 168, 1986, S. 847-851 werden Bauelemente mit mehrfachen Potentialtopfschichten (quantum wells) und Heterostrukturen mit gestuftem Indexprofil und separater Trägerführung (graded index separated carrier confinement heterostructure GRIN-Sch) beschrieben.

Weitere Arbeiten zur Beschreibung des Standes der Technik sind die US-PS 4 006 432, die US-PS 3 970 959, die US-PS 4 743 083, die veröffentlichte europäische Patentanmeldung mit der Veröffentlichungsnummer 0 228 088, die JP-PS 60-186083.

## Ansprüche

1. Anordnung mit einem flächig sich erstreckenden Dünnfilmwellenleiter (DFW), **dadurch gekennzeichnet,** daß in oder an dem Dünnfilmwellenleiter (DFW) eine Struktur aus mehreren mit Abstand (d) nebeneinander verlaufenden Streifenwellenleitern (StW, StW4) und ein Beugungsgitter (BG1, BG2, BG3, BG4) mit in Richtung (x-Richtung) quer zur Verlaufsrichtung (y-Richtung) der Streifenwellenleiter (StW, StW4) verlaufenden Gitterlinien (GL1, GL4) ausgebildet sind, wobei der Abstand ($b_1$, $b_4$) zwischen benachbarten Gitterlinien (GL1) mindestens gleich der Hälfte der Wellenlänge ($\lambda$) einer im Dünnfilmwellenleiter (DFW) und in den Streifenwellenleitern (StW, StW4) ausbreitungsfähigen elektromagnetischen oder akustischen Welle ist.

2. Anordnung nach Anspruch 1, **dadurch gekennzeichnet,** daß der Abstand ($b_1$, $b_4$) zwischen benachbarten Gitterlinien (G11) mindestens gleich der Wellenlänge ( $\lambda$) ist.

3. Anordnung nach Anspruch 1 oder 2, **dadurch gekennzeichnet,** daß die Struktur der Streifenwellenleiter (StW) und das Beugungsgitter (BG1, BG2, BG3, BG4) einander überlagert sind.

4. Anordnung nach einem der vorhergehenden Ansprüche, **dadurch gekennzeichnet,** daß das Beugungsgitter (BG1) einen inneren Gitterbereich (B1) mit dem einen Abstand ($b_1$) zwischen benachbarten Gitterlinien (GL1) aufweist, der zwischen zwei äußeren Gitterbereichen (B2, B3) dieses Gitters (BG1) mit einem anderen Abstand ($b_2$) zwischen benachbarten Gitterlinien (GL2) angeordnet ist, wobei der andere Abstand ($b_2$), bezogen auf die Wellenlänge einer im Dünnfilmwellenleiter und in den Streifenleitern der äußeren Bereiche (B2, B3) geführten Welle, etwa halb so groß ist wie der eine Abstand ($b_1$), bezogen auf die Wellenlänge einer im Dünnfilmwellenleiter (DFW) und in den Streifenleitern (StW) des inneren Bereichs (B1) geführten Welle.

5. Anordnung nach einem der vorhergehenden Ansprüche, **dadurch gekennzeichnet,** daß das Beugungsgitter (BG2) mit dem einen Abstand ($b_1$) zwischen benachbarten Gitterlinien (GL1) einen Phasensprung (PSp) um etwa ein Viertel dieses einen Abstandes ($b_1$) zwischen benachbarten Gitterlinien (GL1) oder um etwa ein ungeradzahliges Vielfaches dieses Viertels aufweist.

6. Anordnung nach einem der vorhergehenden Ansprüche, **dadurch gekennzeichnet,** daß zumindest an stirnseitigen Endflächen (EF) mindestens einer der Schichten (MS1, zS, MS2) mindestens einer der Streifenwellenleiter (StW, StW4) Spiegel (Sp1) vorgesehen sind.

7. Anordnung nach einem der vorhergehenden Ansprüche, **dadurch gekennzeichnet,** daß an seitlichen Endflächen (sE1, sE2) mindestens einer Schicht (MS1, zS, MS2) des Dünnfilmwellenleiters (DFW), die etwa in der Verlaufsrichtung (y-Richtung) der Streifenwellenleiter (StW, StW4) verlaufen, Spiegel (Sp2) vorgesehen sind.

8. Anordnung nach einem der vorhergehenden Ansprüche, **dadurch gekennzeichnet,** daß im Strahlengang einer in einer Richtung (entgegengesetzt zur z-Richtung oder in z-Richtung) senkrecht zur Verlaufsrichtung (y-Richtung) der Streifenwellenleiter (StW, StW4) und senkrecht zur Richtung (x-Richtung) der Gitterlinien (GL1, GL2, GL4) aus dem Dünnfilmwellenleiter (DFW) herausstrahlenden Welle ein Spiegel (Sp3) angeordnet ist.

9. Anordnung nach einem der vorhergehenden Ansprüche, **dadurch gekennzeichnet,** daß der Dünnfilmwellenleiter (DFW) eine Schicht (zS, MS1, MS2) aufweist, die aus der Gruppe Metall, Isolator ausgewählt ist.

10. Anspruch nach einem der vorhergehenden Ansprüche, **dadurch gekennzeichnet,** daß das Gitter sich zumindest teilweise in der Grenzfläche einer Schicht (MS1, MS2) befindet, die aus der Gruppe Metall, Isolator ausgewählt ist.

11. Anordnung nach einem der vorhergehenden Ansprüche, **dadurch gekennzeichnet,** daß der flächige Dünnfilmwellenleiter (DFW) gekrümmt ist.

12. Anordnung nach Anspruch 11, **dadurch gekennzeichnet,** daß der Dünnfilmwellenleiter (DFW) zweifach gekrümmt ist.

13. Anordnung· nach Anspruch 12, **dadurch gekennzeichnet,** daß der Dünnfilmwellenleiter (DFW) sphärisch gekrümmt ist.

14. Anordnung nach einem der vorhergehenden Ansprüche, **dadurch gekennzeichnet,** daß die Streifenwellenleiter (StW, StW4) in einem so geringen Abstand (d) nebeneinander verlaufen, daß in den Streifenwellenleitern (StW, StW4) in deren Verlaufsrichtung (y-Richtung) geführte elektromagnetische oder akustische Wellen miteinander verkoppelt sind.

15. Anordnung nach einem der vorhergehenden Ansprüche, **dadurch gekennzeichnet,** daß der Dünnfilmwellenleiter (DFW) eine Doppelheterostruktur aufweist.

16. Anordnung nach einem der vorhergehenden Ansprüche, **dadurch gekennzeichnet,** daß der Dünnfilmwellenleiter (DFW) eine Schicht (zS) aus $Al_xGa_{1-x}As$ oder aus $GA_xIn_{1-x}As_yP_{1-y}$ aufweist.

17. Anordnung nach einem der vohergehenden Ansprüche, **dadurch gekennzeichnet,** daß der Dünnfilmwellenleiter (DFW) Potentialtopfschichten aufweist.

18. Anordnung nach einem der vorhergehenden Ansprüche, **dadurch gekennzeichnet,** daß ein Streifenwellenleiter (StW, StW4) in Form eines Steges ausgebildet ist.

19. Anordnung nach einem der vorhergehenden Ansprüche, **dadurch gekennzeichnet,** daß ein Streifenwellenleiter (StW, StW4) in Form eines vergrabenen Wellenleiters ausgebildet ist.

20. Anordnung nach einem der vorhergehenden Ansprüche, **dadurch gekennzeichnet,** daß ein Streifenwellenleiter (StW, StW4) in Form eines Wellenleiters mit zumindest teilweise umgeordneten Potentialtopfschichten ausgebildet ist.

21. Anordnung nach einem der vorhergehenden Ansprüche, **dadurch gekennzeichnet,** daß die Gitterlinien (GL1, GL2, GL4) eines Beugungsgitters (BG1, BG2, BG3, BG4)durch Stege oder/und durch die Stege voneinander trennende Gräben definiert sind und daß die Breite ($s_1$, $s_2$) der Stege und die Breite ($g_1$, $g_2$) der Gräben in Bereichen (B1, B2, B3, B4, B5) mit festem Abstand ($b_1$, $b_2$) zwischen benachbarten Gitterlinien (GL1, GL2) gleich groß ist oder daß die Breite ($s_0$) der Stege in Bereichen (BG1, BG2, BG3) mit festem Abstand ($b_1$, $b_2$) zwischen benachbarten Gitterlinien (GL1, GL4) dreimal so groß ist wie die Breite ($g_0$) der Gräben.

22. Anordnung nach einem der vorhergehenden Ansprüche, insbesondere nach Anspruch 14, **dadurch gekennzeichnet,** daß der Dünnfilmwellenleiter (DFW) Material (in LS) mit der Fähigkeit optisch zu verstärken enthält, und daß am Dünnfilmwellenleiter (DFW) Mittel zur Erzeugung von elektrischen Ladungsträgern im Material mit der Fähigkeit, optisch zu verstärken, vorhanden sind.

23. Anordnung nach einem der vorhergehenden Ansprüche, insbesondere nach Anspruch 22, **dadurch gekenn zeichnet,** daß der Dünnfilmwellenleiter (DFW) eine pin-Struktur und Mittel zur Beeinflussung der Verteilung der elektrischen Ladungsträger in dieser pin-Struktur enthält, und daß die Ausbreitung einer geführten elektromagnetischen Welle durch die Verteilung der elektrischen Ladungsträger beeinflußbar ist.

24. Anordnung nach Anspruch 22 oder 23, **dadurch gekennzeichnet,** daß die Ausdehnung des stehenden Wellenfeldes in Verlaufsrichtung mindestens eines der Streifenleiter kürzer als 300 Wellenlängen der in diesem Streifenleiter geführten Welle ist.

25. Anordnung nach einem der vorhergehenden Ansprüche, **dadurch gekennzeichnet,** daß sich die Gitterlinien in Verlaufsrichtung mindestens eines der Streifenleiter über weniger als 300 Wellenlängen der in diesem Streifenleiter geführten Welle erstrecken.

26. Anordnung nach einem der Ansprüche 22 bis 25, **dadurch gekennzeichnet,** daß die Streifenwellenleiter (StW4) in einem inneren Bereich (B6) des Dünnfilmwellenleiters (DFW) unterbrochen sind und/oder in einem außerhalb der inneren Bereiche (B6, B7) liegenden Bereichs (B4, B5) des Dünnfilmwellenleiters (DFW) vorgesehen sind.

27. Anwendung einer Anordnung nach einem der Ansprüche 22 bis 26 als Halbleiterinjektionslaser mit Emission in einer zur Verlaufsrichtung (y-Richtung) der Streifenwellenleiter (StW4) und zur Verlaufsrichtung (x-Richtung) der Gitterlinien (GL1 bis GL4) senkrecht verlaufenden Richtung (z-Richtung oder entgegengesetzt dazu), wobei im Dünnfilmwellenleiter (DFW) eine elektromagnetische Welle durch Injektion von Ladungsträgern erzeugt wird.

28. Anordnung mit einem sich flächig erstreckenden Dünnfilmwellenleiter (DFW), **dadurch gekennzeichnet,** daß in oder an dem Dünnfilmwellenleiter (DFW) eine Struktur aus mehreren mit Abstand (d) nebeneinander verlaufenden Streifenwellenleitern (StW, StW4) ausgebildet ist und daß der Dünnfilmwellenleiter (DFW) eine pin-Struktur und Mittel zur Beeinflussung der Verteilung der elektrischen Ladungsträger in dieser pin-Struktur enthält und daß die Ausbreitung einer im Dünnfilmwellenleiter (DFW) geführten elektromagnetischen Welle durch die Verteilung der elektrischen Ladungsträger beeinflußbar ist.

29. Anordnung nach Anspruch 28, **dadurch gekennzeichnet,** daß die Streifenwellenleiter (StW, StW4) in einem so geringen Abstand (d) nebeneinander verlaufen, daß in den Streifenwellenleitern (StW, StW4) in deren Verlaufsrichtung (y-Richtung) geführte elektromagnetische Wellen miteinander verkoppelt sind.

30. Anordnung nach Anspruch 28, **dadurch gekennzeichnet,** daß der Dünnfilmwellenleiter (DFW) Material (in LS) mit der Fähigkeit, optisch zu verstärken, enthält und daß am Dünnfilmwellenleiter (DFW) Mittel zur Erzeugung von elektrischen Ladungsträgern im Material mit der Fähigkeit, optisch zu verstärken, vorhanden sind.

31. Anordnung nach Anspruch 28, **dadurch gekennzeichnet,** daß in oder an dem Dünnfilmwellenleiter (DFW) ein Beugungsgitter (BG1, BG2, BG3, BG4) mit in Richtung (x-Richtung) quer zur Verlaufsrichtung (y-Richtung) der Streifenwellenleiter (StW, StW4) verlaufenden Gitterlinien (GL1, GL4) ausgebildet ist, wobei der Abstand $(b_1, b_4)$ zwischen benachbarten Gitterlinien (GL1) mindestens gleich der Hälfte der Wellenlänge $(\lambda)$ einer im Dünnfilmwellenleiter (DFW) und in den Streifenwellenleitern (StW, StW4) ausbreitungsfähigen elektromagnetischen Welle ist.

# FIG 1

# FIG 2

# FIG 3

FIG 4

# FIG 5

opt. Gewinn (bel.Einh.) →

G

$V_2$

$V_1$

0

Wellenlänge (bel.Einh.) →